# FASCICULE DE BREVET EUROPEEN

(11) **EP 2 904 927 B1**
(45) Date de publication et mention de la délivrance du brevet: **29.06.2016**
(21) Numéro de dépôt: 14200431.6
(22) Date de dépôt: 29.12.2014
(51) Int. Cl.: A45D 34/00, G06F 1/32, H03K 17/96

(54) **Récipient intéragissant avec un utilisateur à consommation énergétique réduite avant déballage**
Behälter, der vor dem Auspacken mit einem Nutzer mit niedrigem Energieverbrauch interagiert
Container interacting with a user with reduced power consumption prior to unpacking

(30) Priorité: 06.01.2014 FR 1450049
(43) Date de publication de la demande: 12.08.2015
(73) Titulaire: Commissariat à l'Énergie Atomique et aux Énergies Alternatives, 75015 Paris (FR)
(72) Inventeur: Mainguet, Jean-François, 38100 Grenoble (FR); Arrizabalaga, Gorka, 38250 Lans en Vercors (FR); Aubouy, Miguel, 38000 Grenoble (FR)
(74) Mandataire: Brevalex

(56) Documents cités:
- EP-A1- 2 572 603
- DE-A1-102004 034 585
- DE-U1-202004 013 766
- US-A1- 2005 206 769

## Description

### DOMAINE TECHNIQUE

L'invention concerne les récipients, et en particulier les récipients destinés à recevoir du fluide et à interagir avec un utilisateur, comme par exemple des flacons de parfum équipés d'un éclairage à déclenchement commandé par l'utilisateur.

### ÉTAT DE LA TECHNIQUE ANTÉRIEURE

Des récipients sont notamment utilisés pour stocker des produits de consommation, tels que des boissons ou des parfums. Par exemple, les parfums sont le plus souvent distribués dans des flacons munis de bouchons permettant d'éviter le déversement incontrôlé du parfum stocké. Il existe une demande croissante pour que le flacon interagisse avec l'utilisateur, en générant par exemple un signal lumineux lorsque l'utilisateur manipule le flacon. De tels flacons sont par exemple souhaités pour démarquer un type de parfum de la concurrence.

Un flacon connu comporte un bouchon et un éclairage par diode électroluminescente. Lors de la manipulation d'un interrupteur du bouchon, la diode électroluminescente émet un signal lumineux. Un tel éclairage présente des fonctionnalités relativement limitées. L'intensité lumineuse émise par un tel flacon ne prend notamment pas en compte la distance avec l'utilisateur, car basée seulement sur un mode tout ou rien. D'autre part, un tel flacon ne génère de la lumière que lorsque l'utilisateur agit sur le bouchon et ne permet pas de créer un éclairage différencié pour la manipulation d'autres zones du flacon. En outre, un tel éclairage ne réagit qu'à la manipulation d'un interrupteur et non à des gestes plus simples tels que le simple maintien du flacon.

Une solution à ces problèmes consiste à remplacer l'interrupteur par un détecteur de proximité, par exemple un détecteur capacitif, apte à détecter une action d'un utilisateur à proximité ou au contact d'une surface du récipient. Le détecteur de proximité est alors associé à un circuit de contrôle qui génère un signal de commande pour l'exécution d'une séquence lumineuse suite à une détection d'action par le détecteur de proximité.

On cherche toutefois à ce que l'utilisateur puisse, après déballage du flacon de son emballage, initier l'exécution d'une séquence lumineuse lorsqu'il touche, par exemple, une pièce, dite frette, qui recouvre l'épaule du flacon, mais sans qu'il n'ait rien à faire de particulier (ou sans qu'il s'en rende compte) afin de démarrer la détection de proximité et l'éclairage lors de la première utilisation.

Ceci implique que le système de détection de proximité et d'éclairage soit déjà sous tension et activé lors du déballage. Se pose alors le problème de la durée des piles, qui sont nécessairement petites, du type pile bouton, alors que le flacon peut rester emballé jusqu'à une année entière. L'énergie de la pile est ainsi indûment dépensée avant utilisation par le consommateur, venant de facto limiter la durée de vie du flacon lumineux lorsqu'il est entre les mains de l'utilisateur.

Les différentes phases de vie sont les suivantes. Dans une première phase dite de fabrication, la carte électronique portant le circuit de contrôle et le détecteur de proximité est fabriquée et n'est pas encore alimentée. Elle subit certains tests, puis est placée dans un emballage adéquat, prête à être assemblée. Dans une deuxième phase dite d'assemblage, la carte électronique est assemblée avec des pièces plastiques dites d'habillage et les piles, et testée. La consommation d'énergie commence. Dans une troisième phase dite d'embouteillage, encore appelée phase de conditionnement, la frette contenant la carte est assemblée avec le flacon rempli et sa pompe, puis le tout est inséré dans un emballage dit secondaire. Dans une quatrième phase dite de stockage, l'ensemble emballé est stocké, transporté et mis en rayon dans le circuit de distribution, et attend d'être ouvert chez l'utilisateur final. Dans une cinquième phase dite de déballage, le flacon est déballé par l'utilisateur et le système de détection de proximité et d'éclairage peut alors démarrer automatiquement puisque déjà sous tension depuis la phase d'assemblage. Dans une sixième phase dite d'utilisation, à chaque contact avec la frette, une séquence lumineuse est jouée.

### EXPOSÉ DE L'INVENTION

L'invention a pour objectif de répondre à cette problématique de consommation indue dans les phases en amont des phases de déballage et d'utilisation. Elle propose à cet égard d'économiser l'énergie des piles depuis la fabrication d'un récipient à interaction avec un utilisateur jusqu'à sa première utilisation par l'utilisateur, et propose plus précisément un récipient pour le stockage d'un objet, comprenant un capteur de proximité apte à détecter une action d'un utilisateur à proximité ou au contact d'une surface du récipient, un transducteur et un circuit de contrôle comprenant une entrée apte à être couplée au capteur de proximité et une sortie connectée au transducteur, le circuit de contrôle étant configuré pour générer un signal de commande à destination du transducteur lorsqu'une action d'un utilisateur est détectée par le capteur de proximité, caractérisé en ce qu'il comporte en outre un détecteur de déballage couplé au circuit de contrôle et en ce que le circuit de contrôle est en outre configuré pour, suite au retrait du récipient d'un emballage détecté par le détecteur de déballage, basculer d'un mode de veille où il se réveille périodiquement pour interroger le détecteur de déballage à un mode de détection où il vérifie périodiquement l'état de son entrée apte à être couplée au capteur de proximité.

L'invention porte également sur un procédé de gestion de la consommation énergétique d'un tel récipient de stockage d'un objet, caractérisé par le basculement, suite à une détection du retrait du récipient d'un emballage par le détecteur d'emballage, du circuit de contrôle d'un mode de veille où il se réveille périodiquement pour interroger le détecteur de déballage à un mode de détection où il vérifie périodiquement l'état de son entrée apte à être couplée connectée au capteur de proximité.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est une vue de face d'un récipient 1 pour le stockage d'un objet selon un mode de réalisation possible de l'invention ;
- la figure 2 est un schéma illustrant les composants intégrés dans une pièce d'habillage d'un conteneur destiné à recevoir l'objet dans un mode de réalisation possible de l'invention.

### EXPOSÉ DÉTAILLÉ DE MODES DE RÉALISATION PARTICULIERS

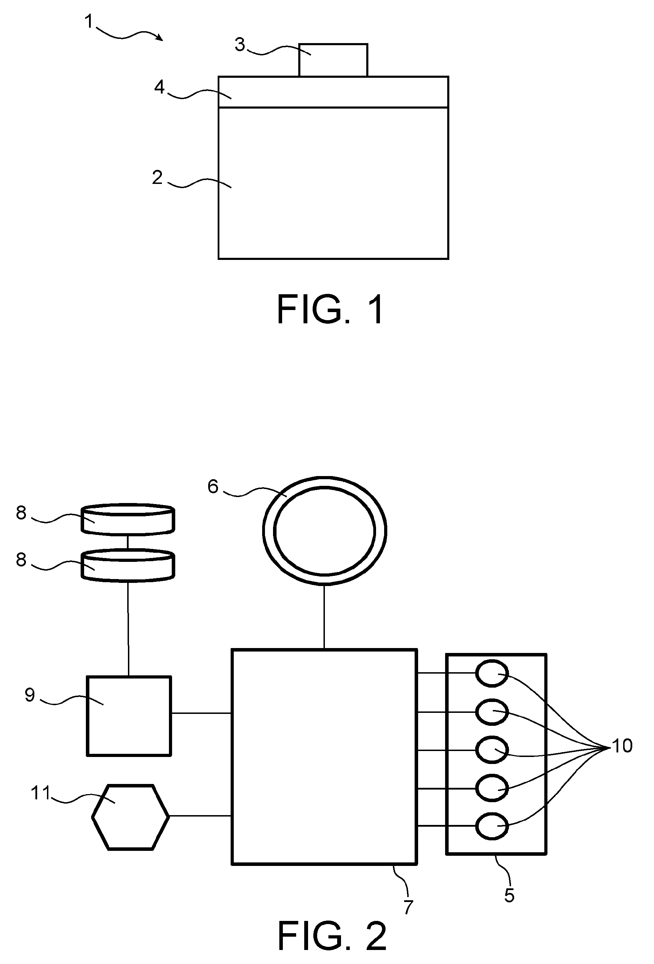

La figure 1 est une vue de face d'un récipient 1 pour le stockage d'un objet selon un mode de réalisation possible de l'invention. Dans l'exemple décrit, l'objet est une poudre ou un fluide cosmétique, tel que du parfum ou une crème. Bien que les exemples décrits par la suite portent plus précisément sur un flacon, l'invention s'applique bien entendu à tout autre récipient, tel qu'une bouteille destinée à contenir une boisson, un pot contenant une crème, ou un étui renfermant un objet.

Le récipient 1 comprend un conteneur 2 destiné à recevoir l'objet, un bouchon 3 et une pièce d'habillage 4 dite frette du conteneur 2 qui en recouvre la partie supérieure et présente un orifice central permettant le passage d'un goulot du conteneur équipé d'une pompe, éventuellement recouverte d'un cache-pompe, autre pièce d'habillage masquant l'orifice de la pompe (non représentée).

En référence à la figure 2, on retrouve intégrés dans la pièce d'habillage 4 un (ou plusieurs) transducteur(s) 5, un (ou plusieurs) capteur(s) de proximité 6 apte(s) à détecter une action d'un utilisateur à proximité ou au contact d'une surface du récipient (la surface supérieure ou latérale de la pièce d'habillage 4 dans cet exemple) et un circuit de contrôle 7 comprenant une (ou plusieurs) entrée(s) chacune apte à être couplée, par exemple électriquement ou capacitivement, à un capteur de proximité et une (ou plusieurs) sortie(s) chacune connectée à un transducteur, le circuit de contrôle étant configuré pour générer un signal de commande à destination d'un transducteur lorsqu'une action d'un utilisateur est détectée par un capteur de proximité. On retrouve également dans la pièce d'habillage 4 une batterie, par exemple sous la forme de piles bouton 8, pour l'alimentation électrique du circuit de contrôle 7, du capteur de proximité 6, du transducteur 5, et le cas échéant d'un régulateur de tension 9.

Le transducteur est par exemple un haut-parleur, un actionneur ou une source lumineuse, par exemple à diodes électroluminescentes 10. Le détecteur de proximité peut être un détecteur de proximité capacitif, par exemple formé d'une pastille métallique électriquement conductrice déposée sur la face interne de la pièce d'habillage 4, et reliée au circuit de contrôle 7. On prendra par la suite l'exemple d'une source lumineuse commandée par l'interaction d'un utilisateur avec un capteur de proximité capacitif, sans que pour autant cela ne soit limitatif.

Dans le cadre de l'invention, le circuit de contrôle est configuré pour pouvoir basculer entre plusieurs modes de fonctionnement dans lesquels sa consommation énergétique ne sera pas la même. Le circuit de contrôle peut ainsi fonctionner dans un mode de veille où il consomme peu, ou encore dans un mode de détection où il consomme plus.

Le basculement entre ces modes de fonctionnement est réalisé au moyen d'un détecteur de déballage 11 dont est doté le récipient selon l'invention. Le circuit de contrôle est ainsi plus précisément configuré pour, suite au retrait du récipient d'un emballage détecté par le détecteur de déballage, basculer du mode de veille où il se réveille périodiquement pour interroger le détecteur de déballage au mode de détection où il vérifie périodiquement l'état de son entrée couplée au capteur de proximité.

La période de réveil dans le mode de veille est plus importante que la période de vérification du mode de détection, typiquement d'un facteur au moins égal à dix, de préférence d'un facteur au moins égal à cent.

Dans le mode de veille, le circuit de contrôle se réveille périodiquement, par exemple toutes les 20 secondes, pour regarder l'état du détecteur de déballage. Pendant la courte période de réveil, la consommation augmente drastiquement (des milliampères) mais elle reste courte (des millisecondes) et donc l'énergie globalement utilisée reste faible. Ce réveil ne concerne qu'une surveillance de l'état du détecteur de déballage. Ainsi en mode de veille, l'état du capteur de proximité n'est pas surveillé.

Dans le mode de détection, le circuit de contrôle vérifie périodiquement, par exemple tous les dixièmes de seconde, l'état du capteur de proximité, et décide s'il y a lieu de démarrer une séquence lumineuse. Il suit de préférence les variations lentes de capacité afin de limiter les déclenchements intempestifs dans le cas de variations des conditions d'environnement. Dans ce mode de détection, l'état du capteur de déballage peut ne pas être surveillé.

Lorsqu'une séquence lumineuse est jouée, la consommation électrique est maximale, et le circuit de contrôle tourne à plein régime. Durant l'exécution de la séquence, il vérifie périodiquement si le contact/proximité de l'utilisateur est toujours présent pour prolonger la séquence. Si le contact/proximité n'est plus détecté, il termine la séquence lumineuse, s'éteint et inhibe la détection de contact durant une seconde (par exemple), avant de retourner dans le mode de détection. Si jamais la séquence lumineuse dure trop longtemps (plus d'une minute par exemple), la séquence lumineuse peut être arbitrairement arrêtée et une calibration peut être réalisée à titre de sécurité, par exemple si jamais il s'agissait d'un déclenchement intempestif provoqué par une variation d'environnement seule.

On comprend donc que l'invention permet d'obtenir une faible consommation au cours des phases qui précèdent l'utilisation du récipient par un utilisateur, c'est-à-dire avant le retrait du récipient de son emballage.

Un exemple de détecteur de déballage est un détecteur magnétique piloté par le circuit de contrôle, par exemple un relais reed ou un magnétomètre. Ce détecteur magnétique interagit avec un aimant placé dans l'emballage. Le circuit de contrôle fonctionne alors dans le mode de veille. Lors du retrait du récipient de l'emballage, cette interaction est rompue et le circuit de contrôle vient alors basculer dans le mode de détection.

Le détecteur de déballage peut également prendre la forme d'un détecteur de distance permettant de mesurer la distance entre le récipient et son emballage, par exemple un détecteur à ultrason ou à induction.

Encore un autre exemple de détecteur de déballage pouvant être utilisé est celui d'un détecteur de lumière disposé sur le récipient de manière à pouvoir détecter la lumière ambiante, tel qu'un phototransistor, une diode PIN, ou encore un détecteur de niveau par infrarouge qui réalise généralement, dans un but de compensation, une mesure de la lumière ambiante. Un emballage de flacon est en effet typiquement un carton étanche à la lumière, et le capteur de lumière se retrouve donc dans le noir avant le retrait du flacon de l'emballage par l'utilisateur.

Un montage possible correspond à l'association série d'un phototransistor avec une résistance, le circuit de contrôle venant, en mode de veille, périodiquement observer la tension aux bornes de la résistance en alimentant l'association série. S'il y a de la lumière, le phototransistor conduit le courant, et la tension observée va à la masse. La valeur de la résistance permet d'ajuster le seuil en fonction des caractéristiques du phototransistor. On utilise de préférence une valeur de résistance élevée (de 500 kΩ ou de 1 MΩ par exemple) de manière à détecter un faible niveau de lumière. Ce montage peut par ailleurs être raffiné, par exemple en utilisant plusieurs résistances alimentées séquentiellement pour détecter différents niveaux de luminosité. Ceci permet notamment de régler l'intensité de la source lumineuse 10 en ajustant son courant moyen à l'aide du circuit de contrôle 7.

Dans un mode de réalisation possible, lorsque le détecteur de déballage prend la forme d'un détecteur de lumière, le circuit de contrôle peut en outre être configuré pour, suite au retrait du récipient de l'emballage, basculer du mode de détection au mode de veille en absence de détection de lumière par le détecteur de déballage pendant une durée déterminée, et pour rebasculer en mode de détection suite à une détection de lumière par le détecteur de déballage.

On peut ainsi définir un critère de stockage du type « pas de lumière pendant 2 jours» ou « pas de lumière pendant 2 heures ». En mode de détection, le circuit de contrôle 7 compte ainsi le temps écoulé depuis la dernière fois que le détecteur de lumière a vu de la lumière, et si le critère d'expiration de durée déterminée est rempli, alors le circuit de contrôle bascule en mode de veille. A partir de ce moment-là, le circuit de contrôle se réveille périodiquement pour interroger le détecteur de lumière et le cas échéant basculer à nouveau en mode de détection.

Dans un autre mode de réalisation possible, lorsque le détecteur de déballage prend la forme d'un détecteur de lumière, le circuit de contrôle peut en outre être configuré pour, en mode de détection, augmenter la période de vérification de l'état de l'entrée couplée au capteur de proximité en absence de détection de lumière par le détecteur de déballage.

Lorsque l'on constate que la luminosité est nulle, par exemple parce que le flacon est rangé dans un placard, on peut ainsi espacer les instants de vérification de l'état de l'entrée couplée au capteur de proximité 6, et ainsi diminuer la consommation énergétique. Un retour à la période de vérification initiale peut par ailleurs être réalisée lorsque l'on constate une luminosité non nulle au moyen du détecteur de lumière, par exemple lorsque le flacon est sorti du placard.

Dans un autre mode de réalisation, le circuit de contrôle 7 peut en outre être configuré pour, en mode de détection, augmenter la période de vérification de l'état de l'entrée couplée au capteur de proximité 6 après une durée déterminée suivant une détection par le capteur de proximité d'une action de l'utilisateur.

Lorsque l'on vient de réaliser une séquence lumineuse, la probabilité pour qu'une nouvelle détection se produise juste après est très élevée. Mais il est probable qu'au bout d'un certain temps, par exemple une dizaine de minutes, la prochaine détection ne se produit que le lendemain par exemple. On peut ainsi tirer parti de ce type fréquent d'utilisation pour augmenter la période de vérification de la détection avec le temps. Un retour à la période de vérification initiale peut par ailleurs être réalisé à l'expiration d'une durée prédéterminée, par exemple au bout de 24 heures pour tirer parti d'un usage journalier.

Dans un autre mode de réalisation, le circuit de contrôle 7 peut être configuré pour, en mode de détection, réaliser un apprentissage d'historique d'action et modifier dans le temps, en fonction de cet apprentissage, la période de vérification de l'état de l'entrée couplée au capteur de proximité.

Le circuit de contrôle 7 peut ainsi réaliser un apprentissage des habitudes de l'utilisateur, comme par exemple apprendre que le récipient est fréquemment utilisé dans un créneau temporel donné. Le circuit de contrôle vient alors définir la période de vérification en fonction de cet historique d'utilisation, en augmentant cette période durant les créneaux temporels d'utilisation fréquente et en la diminuant durant d'autres créneaux.

Dans un autre mode de réalisation, le circuit de contrôle 7 peut être configuré pour, en mode de veille, modifier la période de réveil pour interrogation du détecteur de déballage, par exemple en la réduisant progressivement.

Par exemple, à l'issue de la phase d'assemblage où la consommation d'énergie commence, on peut décider d'avoir une période de réveil plutôt importante dans les premiers jours puis de la réduire, par exemple progressivement.

Cette modification de la période de réveil peut également utiliser les informations du détecteur de lumière pour détecter la phase d'embouteillage. La période de réveil peut alors être modifiée pour reprendre une valeur plutôt importante dans les premiers jours suivant l'embouteillage et diminuer ensuite, par exemple progressivement.

Dans un autre mode de réalisation, le circuit de contrôle peut être configuré pour basculer d'un mode de sommeil dans lequel l'interrogation du détecteur de déballage 11 est inhibée par comparaison au mode de veille.

Par exemple, le circuit de contrôle 7 entre dans le mode de sommeil à l'issue de la phase d'assemblage, par exemple pendant deux jours. A l'issue de cette durée d'inhibition, le circuit de contrôle entre dans son mode de veille pour surveiller le déballage, par exemple au moyen d'une détection de lumière. Lors de la phase d'embouteillage, la détection de lumière peut permettre de faire rebasculer le circuit de contrôle en mode de sommeil, typiquement pendant une durée d'inhibition correspondant à la durée minimale de stockage. A l'issue de cette durée, le circuit de contrôle entre dans son mode de veille.

Dans un autre exemple, le basculement entre le mode de sommeil et le mode de veille est réalisé au moyen d'une action particulière réalisée par exemple lors de la phase d'embouteillage. Un flash lumineux spécifique peut être émis lors de cette phase, qui est détecté par le détecteur de lumière. Reprenant l'exemple du phototransistor, on peut utiliser une autre résistance que celle servant à la détection du déballage pour que le seuil de détection lumineux soit suffisamment haut pour ne pas le confondre avec le seuil servant à la détection du déballage. En variante, une impulsion électromagnétique de fréquence spécifique peut être émise lors de la phase d'embouteillage, cette impulsion étant détectée par une antenne dédiée ou par le capteur de proximité. Selon encore une autre variante, un contact électrique, par exemple un simple court-circuit entre deux pistes du circuit de contrôle, est réalisé pour initier ce basculement du mode de sommeil au mode de veille. Selon encore une autre variante, une pièce en plastique ou en carton, servant par exemple d'emballage provisoire de protection, est retirée ou simplement déplacée lors du montage de la frette sur le flacon. Cette pièce sert de cache-lumière au détecteur de lumière. Lorsqu'elle est retirée ou déplacée, le circuit de contrôle prend connaissance qu'il s'agit du moment où l'embouteillage est réalisé. Alternativement, la pièce peut comporter une piste électrique qui est cassée ou pliée au moment du montage de la frette sur le flacon, ce qui provoque un contact, ou une ouverture de contact, détecté par le circuit de contrôle.

Dans un autre exemple, le basculement entre le mode de sommeil et le mode de veille est réalisé au stade de la vente. Le vendeur dispose par exemple d'un appareil d'activation, similaire à un appareil permettant de désactiver une étiquette antivol, comprenant une antenne de type RFID permettant de transmettre suffisamment d'énergie pour déclencher une interruption du circuit de contrôle et le démarrer, ou encore à l'aide d'une antenne transmettant un signal spécifique.

Dans encore un autre exemple, le récipient peut comprendre un conteneur destiné à contenir l'objet, une pièce d'habillage du conteneur (typiquement une frette) dans laquelle sont intégrés le circuit de contrôle et un détecteur d'assemblage du conteneur et de la pièce d'habillage couplé au circuit de contrôle 7. Le circuit de contrôle est alors configuré pour basculer du mode de sommeil au mode de veille sur détection, par le détecteur d'assemblage, d'un assemblage du conteneur et de la pièce d'habillage.

Si le conteneur et la pièce d'habillage sont destinés à être séparables en utilisation, comme c'est par exemple le cas d'un pot de crème et de son capot, le circuit de contrôle est configuré de manière à mémoriser le premier assemblage pour rester en mode de détection, et non basculer en mode de veille, suite à un nouvel assemblage correspondant par exemple à la fermeture du pot de crème par vissage du capot.

Le détecteur d'assemblage peut notamment prendre la forme d'un détecteur de lumière, par exemple un phototransistor, agencé de manière à être caché après montage avec la pompe et éventuellement son cache-pompe lors de la phase d'embouteillage. La détection d'une absence de lumière permet de détecter que le récipient se trouve en phase d'embouteillage et de basculer en conséquence le circuit de contrôle en mode de veille. Le détecteur d'assemblage peut également prendre la forme d'un magnétomètre venant interagir avec un aimant lors de la phase d'embouteillage.

Le détecteur d'assemblage permet également d'arrêter une séquence lumineuse en cours d'exécution lorsque le capot est séparé du flacon, de manière à éviter d'éblouir l'utilisateur lorsque les diodes électroluminescentes sont directement visibles dans cette configuration.

L'invention n'est pas limitée au récipient tel que décrit précédemment, mais s'étend également à un procédé de gestion de la consommation énergétique d'un tel récipient conformément aux différents modes de réalisation décrit précédemment, et en particulier un procédé caractérisé par le basculement, suite à une détection du retrait du récipient d'un emballage, du circuit de contrôle d'un mode de veille où il se réveille périodiquement pour interroger le détecteur de déballage à un mode de détection où il vérifie périodiquement l'état de son entrée couplée au capteur de proximité.

## Revendications

1. Récipient (1) pour le stockage d'un objet destiné à interagir avec un utilisateur, comprenant un capteur de proximité (6) apte à détecter une action d'un utilisateur à proximité ou au contact d'une surface du récipient, un transducteur (5) et un circuit de contrôle (7) comprenant une entrée apte à être couplée au capteur de proximité et une sortie connectée au transducteur, le circuit de contrôle étant configuré pour générer un signal de commande à destination du transducteur lorsqu'une action d'un utilisateur est détectée par le capteur de proximité,
**caractérisé en ce qu'**il comporte en outre un détecteur de déballage (11) couplé au circuit de contrôle et **en ce que** le circuit de contrôle est en outre configuré pour, suite au retrait du récipient d'un emballage détecté par le détecteur de déballage, basculer d'un mode de veille où il se réveille périodiquement pour interroger le détecteur de déballage à un mode de détection où il vérifie périodiquement l'état de son entrée apte à être couplée au capteur de proximité.

2. Récipient selon la revendication 1, dans lequel le détecteur de déballage (11) est un détecteur magnétique.

3. Récipient selon la revendication 1, dans lequel le détecteur de déballage (11) est un détecteur de lumière.

4. Récipient selon la revendication 3, dans lequel le circuit de contrôle (7) est en outre configuré pour, suite au retrait du récipient de l'emballage, basculer du mode de détection au mode de veille en absence de détection de lumière par le détecteur de déballage (11) pendant une durée déterminée, et pour rebasculer en mode de détection suite à une détection de lumière par le détecteur de déballage.

5. Récipient selon la revendication 3, dans lequel le circuit de contrôle (7) est en outre configuré pour, en mode de détection, augmenter la période de vérification de l'état de l'entrée apte à être couplée au capteur de proximité (6) en absence de détection de lumière par le détecteur de déballage (11).

6. Récipient selon l'une des revendications 1 à 5, dans lequel le circuit de contrôle (7) est en outre configuré pour, en mode de détection, augmenter la période de vérification de l'état de l'entrée apte à être couplée au capteur de proximité (6) après une durée déterminée suivant une détection par le capteur de proximité (6) d'une action de l'utilisateur.

7. Récipient selon l'une des revendications 1 à 5, dans lequel le circuit de contrôle (7) est en outre configuré pour, en mode de détection, réaliser un apprentissage d'historique d'action et modifier dans le temps, en fonction de cet apprentissage, la période de vérification de l'état de l'entrée apte à être couplée au capteur de proximité (6).

8. Récipient selon l'une des revendications 1 à 7, dans lequel le circuit de contrôle (7) est en outre configuré pour, en mode de veille, progressivement réduire la période de réveil pour interrogation du détecteur de déballage (11).

9. Récipient selon l'une des revendications 1 à 8, dans lequel le circuit de contrôle (7) est en outre configuré pour basculer d'un mode de sommeil dans lequel l'interrogation du détecteur de déballage (11) est inhibée au mode de veille.

10. Récipient selon la revendication 9, comprenant un conteneur (2) destiné à contenir l'objet, une pièce d'habillage (4) du conteneur dans laquelle sont intégrés le circuit de contrôle (7) et un détecteur d'assemblage du conteneur et de la pièce d'habillage couplé au circuit de contrôle, le circuit de contrôle étant configuré pour basculer du mode de sommeil au mode de veille sur détection, par le détecteur d'assemblage, d'un assemblage du conteneur et de la pièce d'habillage.

11. Récipient selon l'une des revendications précédentes, comprenant un conteneur (2) contenant un produit cosmétique, notamment du parfum ou de la crème, et dans lequel le capteur de proximité (6) est un capteur capacitif et le transducteur (5) est une source lumineuse dont l'illumination est commandée par le signal de commande généré par le circuit de contrôle.

12. Procédé de gestion de la consommation énergétique d'un récipient (1) de stockage d'un objet, le récipient est destiné à interagir avec un utilisateur, le procédé comprenant un capteur de proximité (6) apte à détecter une action d'un utilisateur à proximité ou au contact d'une surface du récipient, un transducteur (5) et un circuit de contrôle (7) comportant une entrée apte à être couplée au capteur de proximité capacitif et une sortie connectée au transducteur, le circuit de contrôle étant configuré pour générer un signal de commande à destination du transducteur lorsqu'une action d'un utilisateur est détectée par le capteur de proximité, **caractérisé par** le basculement, suite à une détection du retrait du récipient d'un emballage par un détecteur d'emballage (11), du circuit de contrôle (7) d'un mode de veille où il se réveille périodiquement pour interroger le détecteur de déballage (11) à un mode de détection où il vérifie périodiquement l'état de son entrée apte à être couplée connectée au capteur de proximité (6).

## Patentansprüche

1. Gefäß (1) für die Lagerung eines Inhalts, welches dazu bestimmt ist, mit einem Benutzer zu interagieren, wobei das Gefäß einen Näherungssensor (6), welcher in der Lage ist, eine Aktion eines Benutzers, der in der Nähe oder in Kontakt mit einer Oberfläche des Gefäßes ist, zu erfassen, einen Wandler (5) und eine Steuerungsschaltung (7) aufweist, welche einen Eingang umfasst, der mit dem Näherungssensor gekoppelt werden kann, sowie einen Ausgang, der mit dem Wandler verbunden ist, wobei die Steuerungsschaltung konfiguriert ist, um ein für den Wandler bestimmtes Steuersignal zu erzeugen, wenn eine Aktion eines Benutzers durch den Näherungssensor erfasst wird,
**dadurch gekennzeichnet, dass** das Gefäß darüber hinaus einen Auspack-Detektor (11) umfasst, der mit der Steuerungsschaltung verbunden ist, und dass die Steuerungsschaltung darüber hinaus konfiguriert ist, um im Anschluss an das von dem Auspack-Detektor erfasste Entfernen des Gefäßes aus einer Verpackung von einem
Standby-Modus, in welchem sie periodisch erweckt wird, um den Auspack-Detektor zu befragen, in einen Detektionsmodus umzuschalten, in welchem sie den Zustand ihres Eingangs, welcher mit dem Näherungssensor gekoppelt werden kann, periodisch überprüft.

2. Gefäß nach Anspruch 1, in welchem der Auspack-Detektor (11) ein magnetischer Detektor ist.

3. Gefäß nach Anspruch 1, in welchem der Auspack-Detektor (11) ein Lichtdetektor ist.

4. Gefäß nach Anspruch 3, in welchem die Steuerungsschaltung (7) darüber hinaus konfiguriert ist, um im Anschluss an das Entfernen der Verpackung von dem Detektionsmodus in den Standby-Modus umzuschalten, wenn kein Licht von dem Auspack-Detektor (11) während eines vorbestimmten Zeitraums erfasst wird, und um im Anschluss an eine Erfassung von Licht von dem Auspack-Detektor in den Detektionsmodus zurückzuschalten.

5. Gefäß nach Anspruch 3, in welchem die Steuerungs schaltung (7) darüber hinaus konfiguriert ist, um im Detektionsmodus den Überprüfungszeitraum des Zustands des Eingangs, welcher mit dem Näherungssensor (6) bei fehlender Lichterfassung von dem Auspack-Detektor (11) gekoppelt werden kann, zu erhöhen.

6. Gefäß nach einem der Ansprüche 1 bis 5, in welchem die Steuerungsschaltung (7) darüber hinaus konfiguriert ist, um im Detektionsmodus den Überprüfungszeitraum des Zustand des Eingangs, welcher mit dem Näherungssensor (6) nach einem bestimmten Zeitraum im Anschluss an eine Erfassung einer Aktion des Benutzers durch den Näherungssensor gekoppelt werden kann, zu erhöhen.

7. Gefäß nach einem der Ansprüche 1 bis 5, in welchem die Steuerungsschaltung (7) darüber hinaus konfiguriert ist, um im Detektionsmodus ein Lernen des
Aktionsverlaufs zu realisieren und über die Zeit als Funktion dieses Lernvorgangs die Überprüfungszeitdauer des Zustands des Eingangs, der mit dem Näherungssensor (6) gekoppelt werden kann, zu modifizieren.

8. Gefäß nach einem der Ansprüche 1 bis 7, in welchem die Steuerungsschaltung (7) darüber hinaus konfiguriert ist, um im Standby-Modus den Weckzeitraum zur Befragung des Auspack-Detektors (11) schrittweise zu verringern.

9. Gefäß nach einem der Ansprüche 1 bis 8, in welchem die Steuerungsschaltung (7) darüber hinaus konfiguriert ist, um von einem Schlafmodus, in welchem die Befragung des Auspack-Detektors (11) verhindert wird, in einen Standby-Modus umzuschalten.

10. Gefäß nach Anspruch 9, welches einen Behälter (2), welcher zur Aufnahme eines Inhalts bestimmt ist, ein Verkleidungsteil (4) des Behälters, in welchem die Steuerungsschaltung (7) und ein Detektor für den Zusammenbau bzw. die Montage von dem Behälter und dem mit der Steuerungsschaltung gekoppelten Verkleidungsteil integriert sind, umfasst, wobei die Steuerungsschaltung konfiguriert ist, um vom Schlafmodus in den Standby-Modus umzuschalten, wenn der Zusammenbau- bzw. Montage-Detektor einen Zusammenbau des Behälter und des Verkleidungsteils erfasst.

11. Gefäß nach einem der vorhergehenden Ansprüche, welches einen Behälter (2) umfasst, der ein kosmetisches Produkt, insbesondere Parfüm oder Creme, enthält, und in welchem der Näherungssensor (6) ein kapazitiver Sensor ist und der Wandler (5) eine Lichtquelle ist, deren Beleuchtung von dem von der Steuerungsschaltung erzeugten Steuersignal gesteuert wird.

12. Verfahren zur Leitung bzw. Steuerung des Energieverbrauchs eines Gefäßes (1) zur Lagerung eines Inhalts, wobei das Gefäß dazu bestimmt ist, mit einem Benutzer zu interagieren, wobei das Verfahren einen Näherungssensor (6), der in der Lage ist, eine Aktion eines Benutzers in der Nähe von oder in Kontakt mit einer Oberfläche des Gefäßes zu erfassen, einen Wandler (5) und eine Steuerungsschaltung (7) aufweist, welche einen Eingang umfasst, der mit dem kapazitiven Näherungssensor gekoppelt werden kann, sowie einen Ausgang, der mit dem Wandler verbunden ist, wobei die Steuerungsschaltung konfiguriert ist, um ein für den Wandler bestimmtes Steuersignal zu erzeugen, wenn eine Aktion eines Benutzers von dem Näherungssensor erfasst wird, **dadurch gekennzeichnet, dass** die Steuerungschaltung (7) im Anschluss an das von einem Auspack-Detektor (11) erfasste Entfernen des Gefäßes aus der Verpackung von einem Standby-Modus, in welchem sie periodisch erweckt wird, um den Auspack-Detektor (11) zu befragen, in einen Detektionsmodus umschaltet, in welchem sie den Zustand ihres Eingangs, welcher mit dem Näherungssensor gekoppelt werden kann, periodisch überprüft.

## Claims

1. A receptacle (1) for storage of an object, intended to interact with a user, comprising a proximity sensor (6) capable of detecting an action by a user close to or in contact with a surface of the receptacle, a transducer (5) and a control circuit (7) comprising an input that can be coupled to the proximity sensor and an output connected to the transducer, the control circuit being configured to generate a control signal to be sent to the transducer when a user action is detected by the proximity sensor, **characterized in that** the receptacle further comprises an unpacking detector (11) coupled to the control circuit and **in that** the control circuit is further configured to switch from a standby mode during which it periodically awakens to query the unpacking detector to a detection mode during which it periodically checks the state of its input that can be coupled to the proximity sensor, after the unpacking detector has detected removal of the receptacle from a packaging.

2. The receptacle according to claim 1, in which the unpacking detector (11) is a magnetic detector.

3. The receptacle according to claim 1, in which the unpacking detector (11) is a light detector.

4. Receptacle according to claim 3, in which the control circuit (7) is further configured to switch, after the receptacle has been withdrawn from the packaging, from the detection mode to the standby mode after the unpacking detector (11) has not detected any light during a determined period, and to switch back to the detection mode after light is detected by the unpacking detector.

5. The receptacle according to claim 3, in which the control circuit (7) is also configured to increase the period at which a verification is made of the state of the input that can be coupled to the proximity sensor (6) if no light is detected by the unpacking detector (11), when the control circuit is in detection mode.

6. The receptacle according to claim 1, in which the control circuit (7) is also configured so that in detection mode, the verification period of the state of the input that can be coupled to the proximity sensor (6) is increased after a determined duration following detection of a user action by the proximity sensor (6).

7. The receptacle according to claim 1, in which the control circuit (7) is also configured so that an action history can be learned in detection mode, and the verification period of the state of the input that is coupled to the proximity sensor (6) is modified in time as a function of this learning.

8. The receptacle according to claim 1, in which the control circuit (7) is also configured to progressively reduce the awaken period to query the unpacking detector, in standby mode (11).

9. The receptacle according to claim 1, in which the control circuit (7) is also configured to change over from a sleep mode in which querying of the unpacking detector (11) is inhibited to the standby mode.

10. The receptacle according to claim 9, including a container (2) that is aimed at containing the object, a container cladding part (4) in which are integrated the control circuit (7) and a container and cladding part assembly detector coupled to the control circuit, the control circuit being configured to switch from the sleep mode to standby mode when the assembly detector detects assembly of the container and the cladding part.

11. The receptacle according to claim 1, including a container (2) containing a cosmetic product, particularly perfume or cream, and in which the proximity sensor (6) is a capacitive sensor and the transducer (5) is a light source, the lighting of which is controlled by the control signal generated by the control circuit.

12. A method of managing the energy consumption of an object storage receptacle (1), the receptacle being intended to interact with a user, which comprises a proximity sensor (6) capable of detecting an action of a user close to or in contact with a surface of the receptacle, a transducer (5) and a control circuit (7) comprising an input that can be coupled to the capacitive proximity sensor and an output connected to the transducer, the control circuit being configured to generate a control signal to be sent to the transducer when a user action is detected by a proximity sensor, **characterized in that** the control circuit (7) switches from a standby mode during which it awakens periodically to query the unpacking detector (11) to a detection mode, during which it periodically checks the state of its input that can be coupled to the proximity sensor (6), after the unpacking detector (11) has detected removal of the receptacle from a packaging.
